Europäisches Patentamt

European Patent Office

Office européen des brevets

(11) Publication number: **0 301 691**
**A1**

## (12) EUROPEAN PATENT APPLICATION

(21) Application number: 88305373.8

(22) Date of filing: **13.06.88**

(51) Int. Cl.4: **H05K 13/02 , B65G 47/08**

(30) Priority: **31.07.87 GB 8718154**

(43) Date of publication of application:
**01.02.89 Bulletin 89/05**

(84) Designated Contracting States:
**BE CH DE FR GB IT LI NL SE**

(71) Applicant: EMHART INDUSTRIES, INC.
426 Colt Highway
Farmington Connecticut 06032(US)

(72) Inventor: Hawkswell, Victor Thomas
42 Highfields Road
Witham Essex(GB)

(74) Representative: Drury, Peter Lawrence et al
Emhart Patents Department Lyn House 39
The Parade
Oadby, Leicester LE2 5BB(GB)

(54) Magazine for storing electronic components of the soic type.

(57) The components (C) are stored one-behind the other in an inclined track (16). A conveyor belt (30) receives components issuing from the track (16) and conveys them to a collection point (14). Gating means is operable to retain the components in the track and release then one-at-a-time. The gating means comprises a stop (62) movable into and out of an operative position in which a leading component (C1) in the track (16) engages the stop, and a clamping member (74) movable into and out of an operative position in which it clamps a following component (C2) against movement when the stop (62) releases the leading component.

Fig-1

EP 0 301 691 A1

# MAGAZINE FOR STORING ELECTRONIC COMPONENTS OF THE SOIC TYPE

This invention is concerned with a magazine for storing electronic components of the SOIC type.

It is common practice to store electronic components one-behind-the-other in a downwardly-inclined tube or track. The bottom of the tube or track has a stop defining a collection point from which components are collected for use, e.g. for placement on a printed circuit board. The lowermost component rests on the stop until collected and following components are held in the tube or track by said lowermost component. The track or tube may be vibrated to assist the passage of components along the tube or track and reduce the possibility of jamming. Where, however, this type of downwardly-inclined guide is used for storing components of the SOIC type, problems arise because the components have projecting mould flash lines along the surfaces thereof which engage one another. The flash lines of the lowermost and next following component may interlock preventing proper collection of the lowermost component by a pick-up head of an insertion machine. This may prevent operation of the machine for lack of the particular component involved with consequent loss of production.

It is an object of the present invention to provide a magazine in which the electronic components of the SOIC type can be stored and reliably collected therefrom.

The invention provides a magazine for storing electronic components of the SOIC type and operable to deliver the components one-at-a-time to a collection point, the magazine comprising a downwardly-inclined track arranged to store a plurality of components one-behind-the-other, the track comprising an upper guide member, a lower guide member, and two opposed side guide members, characterised in that the magazine also comprises a conveyor belt arranged to receive components issuing from a lower end of the track and arranged to convey each component to the collection point, and gating means operable to retain the components in the track and to release them one-at-a-time on to the conveyor belt, the gating means comprising a stop mounted for movement between an operative position thereof in which it projects into the track so that a leading component in the track engages the stop so that the components are prevented from sliding down the track, and an inoperative position thereof in which the stop is clear of the track, the gating means also comprising a clamping member mounted for movement between an operative position thereof in which it projects into the track and clamps the component following said leading component against one of said guide members thereby preventing the clamped component and following components from sliding down the track, and an inoperative position thereof in which said clamping member is clear of the track, and connecting means connecting said stop and said clamping member arranged to ensure that, as said stop moves into its inoperative position, said clamping member moves into its operative position so that only one component is released from the track and, as said stop moves into its operative position, the clamping member moves into its inoperative position allowing the following components to move up to the stop.

In a magazine according to the last preceding paragraph, the leading component is separated from the following component by the operation of the gating means while still in the track and is conveyed separately to the collection point from which it can be collected without the possibility of being held by the following component.

Preferably, the conveyor belt is arranged to be driven a predetermined distance in response to each operation of the gating means to release a component, said distance being sufficient to carry the released component to the collection point. This ensures that the conveyor belt moves only when necessary.

In order to avoid the necessity for the conveyor belt to make precise movements, preferably a further stop projects across the conveyor belt and acts to define the collection point by preventing movement of a component which engages the stop by movement of the conveyor belt. Preferably, the further stop is adjustable along the conveyor belt to enable adjustment of the collection point or to retain a constant collection point for components of different lengths.

Conveniently, said stop and said clamping member of the gating means are mounted on a pivoted link on opposite sides of the pivot thereof. Thus, the gating means is operated by pivoting the link and it is ensured that the clamping member and stop move simultaneously. Preferably, the spacing along the track of said stop and said clamping member of the gating means is variable to enable the gating means to be adapted to components of various lengths. This can conveniently be achieved by providing alternative mounting points for the stop on the link. The clamping member may be resiliently mounted, e.g. on a spring on said link, so that the clamping member will yield and not apply excessive force to a component.

Conveniently, the clamping member and the stop of the gating means project into the track through a common slot in said lower guide member and the component following the leading component is clamped, when the clamping member is in its operative position, against the upper guide member of the track.

The gating means may be operable by a vertically-disposed piston and cylinder assembly when the gating means is vertically aligned with said assembly. The magazine and other similar magazines can be moved horizontally to and from alignment with the piston and cylinder assembly so that only one such assembly is required for a plurality of magazines.

In order to ensure that components pass from the track on to the conveyor without jamming, the spacing between said upper and said lower guide members may be increased for a portion of the track below said gating means and terminating at the lower end of the track.

The conveyor belt may be driven by a motor arranged to drive the conveyor belts of one or more similar magazines mounted on a common frame with said magazine. This reduces the number of motors required. the motor may operate to drive all the belts whenever a gating means is operated thereby avoiding the requirement for clutches to engage and disengage the drive. However, only one of the conveyor belts will be carrying a component at any one time.

There now follows a detailed description, to be read with reference to the accompanying drawings, of a magazine for storing electronic components which is illustrative of the invention. It is to be understood that the illustrative magazine has been selected for description by way of example and not of limitation of the invention.

In the drawings:

Figure 1 is a side elevational view of the illustrative magazine;

Figure 2 is a plan view of the illustrative magazine and four similar magazines mounted on the same frame as the illustrative magazine; and

Figures 3 and 4 are side elevational views, on a larger scale than Figures 1 and 2, of gating means of the illustrative magazine, Figure 3 showing the gating means in one position thereof and Figure 4 showing the gating means in the other position thereof.

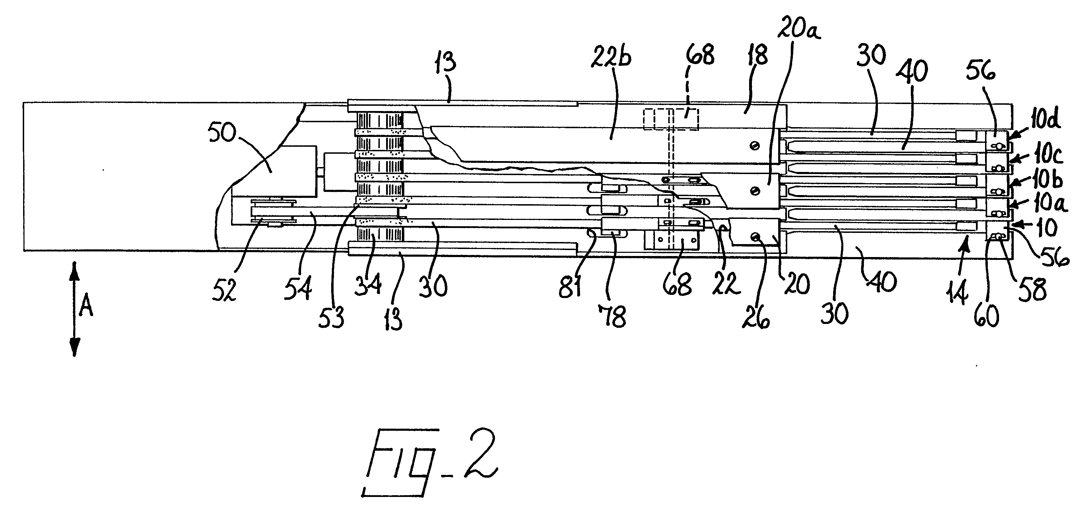

This illustrative magazine 10 is mounted on a common frame 12 with four similar magazines 10a, 10b, 10c and 10d(Figure 2). The five magazines are of identical construction (except where mentioned hereinafter) and like parts are given the same reference numerals in the drawings. The frame 12 comprises two vertically-extending side plates 13 and a base plate 15 connecting the side plates.

The illustrative magazine 10 is for storing electronic components C of the SOIC type which have moulded plastic bodies and leads projecting from the sides thereof. The magazine is operable to deliver the components C one-at-a-time to a collection point 14 from which the components can be removed by a pick-up head (not shown) of an insertion machine.

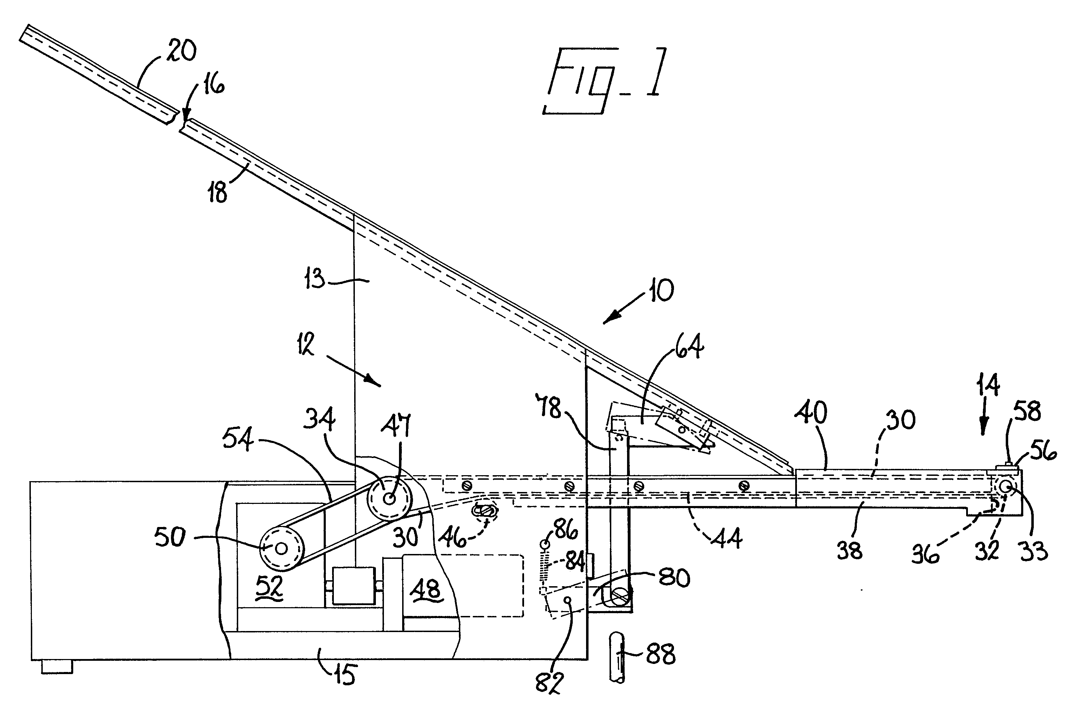

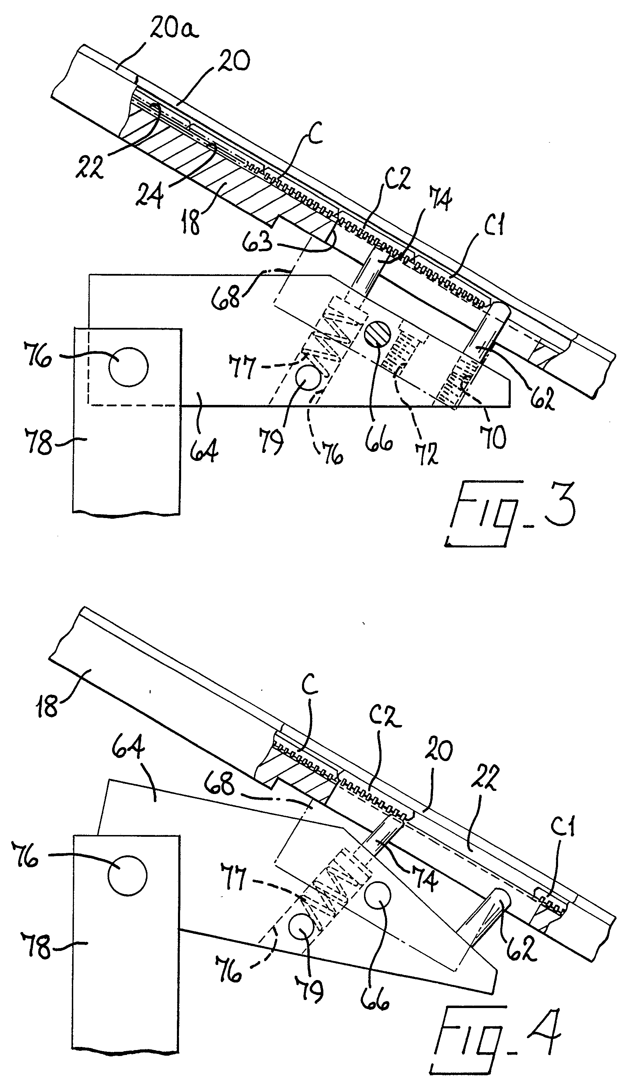

The illustrative magazine 10 comprises a downwardly-inclined track 16 arranged to store a plurality of the components C one-behind the other. The track 16 is defined by a rectangular plate 18 supported by the side plates 13 and an upper guide member 20 bolted to the plate 18. The plate 18 is mounted so that it inclines downwardly (see Figure 1) with one of its shorter edges extending horizontally at the top of the incline and the other extending horizontally at the bottom of the incline. The uppermost of the larger surfaces of the plate 18 has five grooves 22 therein which define the tracks of the five magazines. The lower surface of each groove 22 defines a lower guide member of the track 16 of the magazine and the sides of the groove 22 define two opposed side guide members of the track 16. Two grooves 24 (Figure 3) are formed in the lower surface of each groove 22 to accommodate the leads of the components C. The upper guide member 20 is bolted to the plate 18 by bolts 26 beside the groove 22. The guide member 20 projects over the top of the groove 22 to retain components therein. The upper guide members 20a and 20b of the other four magazines are provided by double-width members bolted to the plate 18 between grooves 22 and each projects across two of the grooves 22.

The illustrative magazine 10 also comprises a conveyor belt 30 arranged to receive components issuing from a lower end of the track 16 and arranged to convey each component to the collection point 14. The conveyor belt 30 extends around an idler pulley 32 mounted adjacent the collection point 14 and a driven roller 34. The idler pulley 32 is mounted in a groove 36 in a front edge of a horizontally-extending plate 38 of the frame 12 which is supported by the side plates 13. From the driven roller 34, the belt 30 passes along the upper surface of the plate 38 to the idler pulley 32, The belt 30 passes beneath the lower end of the track 16 and from there to the idler pulley 32 runs between upward projections 40 of the plate 38 which provide guides preventing components C from slipping off the belt 30. After passing around the idler pulley 32, the belt 30 extends along a groove 44 in the underside of the plate 38, passing over a tensioning roller 46 before returning to the driven roller 34. The driven roller 34 is fixed on a shaft 47 which is driven by an electric motor 48 mounted on the base plate 15 which drives a gear box 50 which has a pulley 52 on an output shaft thereof. A drive belt 54 passes around the pulley 52 and a pulley 53 fixed on the shaft 47. The belts 30 of the other four magazines are driven by the roller 34 so that the single electric motor 48 drives all five belts 30. The idler pulleys 32 of the five magazines are mounted on a common shaft 33 supported by the plate 38. The motor 48 is arranged to drive the conveyor belts 30 of all five magazines mounted on the frame 12 simultaneously.

At the collection point 14, a stop 56 projects across the conveyor belt 30 and acts to define the collection point 14 by preventing movement of a component C which engages the stop 56 by movement of the conveyor belt 30. The stop 56 is bolted to one of the projections 40 beside the belt 30 by a bolt 58. The bolt 58 passes through an elongated slot 60 in the stop 56 so that the position of stop 56 is adjustable along the conveyor belt 30. If desired, the five stops 56 can be adjusted to different positions to accommodate components of different lengths.

The illustrative magazine 10 also comprises gating means operable to retain the components C in the track 16 and to release them one-at-a-time on to the conveyor belt 30. The gating means comprises a stop 62 (Figure 3) mounted for movement between an operative position thereof (shown in Figure 3) in which it projects through a slot 63 in the plate 18 into the track 16 from below so that a leading component C1 in the track engages the stop 62 so that the components are prevented from sliding down the track 16 to the conveyor belt 30, and an inoperative position thereof (shown in Figure 4) in which the stop 62 is clear of the track 16. The stop 62 is formed by a cylindrical pin projecting from a pivoted link 64 pivotally mounted on a shaft 66 supported by two blocks 68 depending from the plate 18. The stop 62 is screwed into a threaded bore 70 in the link 64 to the right (viewing Figures 3 and 4) of the shaft 66. An alternative threaded bore 72 is provided in the link 64 nearer to the shaft 66 than the bore 70 but still to the right thereof. The alternative bore 72 allows the spacing along the track of the stop 62 and a clamping member 74 (to be described) to be varied.

The gating means of the illustrative magazine 10 also comprises a clamping member 74 mounted for movement between an operative position thereof (shown in Figure 4) in which it projects through the slot 63 into the track 16 and clamps the component C2 following said leading component C1 against the upper guide member 20 thereby preventing the clamped component C2 and following components from sliding down the track 16, and an inoperative position thereof (shown in Figure 3) in which said clamping member 74 is clear of the track 16. The member 74 and the stop 62, thus, extend through a common slot 63 in the lower guide member. The clamping member 74 is formed by a headed pin captive in a stepped bore 76 in the link 64 to the left (viewing Figures 3 and 4) of the shaft 66. The clamping member 74 is urged outwardly of the bore 76 by a spring 77 acting between the head of the clamping member 74 and a pin 79 extending across the bore 76. The clamping member 74 is, thus, resiliently mounted in the bore 76 so that it will yield and not apply excessive clamping force to a component.

The link 74 provides connecting means connecting the stop 62 and the clamping member 74 arranged to ensure that, as the stop 62 moves into its inoperative position (by the link 64 pivoting clockwise viewing Figures 3 and 4), the clamping member 74 moves into its operative position. This causes one component to be released from the track 16 on to the conveyor belt 30. As the stop 62 moves into its inoperative position, it releases the leading component C1 while simultaneously the clamping member 74 clamps the component C2 following the leading component against the upper guide member 20. Thus, only one component is released from the track 16. Also, as the stop 62 moves into its operative position, the clamping member 74 simultaneously moves into its inoperative position releasing the clamped component and allowing the following components to move up to the stop 62.

The link 64 is pivotally-connected at 76 to an upper end portion of a vertically-extending link 78 which passes through a slot 81 in the plate 38. A lower end portion of the link 78 is pivotally connected to a lever 80 (Figure 1) which is pivoted on a shaft 82 extending between the side plates 13. A spring 84 acts between a shaft 86, extending between the side plates 13, and the lever 80. The spring 84 acts to urge the lever 80 clockwise (viewing Figure 1) about the shaft 82 so that the lever 78 is pressed downwardly urging the link 64 anti-clockwise about its pivot 66 (viewing Figure 1). This moves the stop 62 into its operative position and the clamping member 74 into its inoperative position. Disposed below the link 78 is a vertically-disposed piston and cylinder assembly (not shown) having an upwardly-extending piston rod 88. The gating means is operable by the piston and cylinder assembly when the gating means is vertically aligned with the assembly. The assembly moves its piston rod 88 upwardly pressing the link 78 upwardly, and pivoting the link 64 clockwise, thereby moving the stop 62 into its inoperative position and the clamping member 74 into its operative position. The frame 12 can be moved horizontally (in the directions indicated by A in Figure 2) to bring the gating means of any of the five tracks 16 into alignment with the piston and cylinder assembly so that the assembly can operate any of the gating means. Indeed, one assembly can operate the gating means of a large number of tracks 16 arranged side-by-side on a plurality of frames.

The spacing between the upper and lower guide members of the track 16 is increased for a portion of the track below the gating means and terminating at the lower end of the track. This is found to assist components in dropping on to the conveyor belt 30 without jamming and is achieved by reducing the thickness of the upper guide member 20 (this reduction is too small to show in the drawings).

In operation, when it is desired to pick-up a component from the illustrative magazine 10, the frame 12 is moved until the lever 80 of the magazine 10 is above the piston rod 88. At this time, the stop 62 is in its operative position holding all the components in the track 16 against movement down the track. The piston and cylinder assembly is now operated causing release of a component as described above. The component falls on to the conveyor belt 30. The motor 48 is arranged to operate to drive the conveyor belt 30 a predetermined distance in response to each operation of the gating means to release a component, i.e. the control impulse to the piston and cylinder assembly which causes it to operate gives rise to a power supply of predetermined duration to the motor 48. The motor 48 drives all five belts 30 but four of them are empty of components. The predetermined distance is sufficient to bring the component to rest against the stop 56 at the collection point 14 from whence the component is picked up by a pick-up head.

## Claims

1. A magazine (10) for storing electronic components of the SOIC type and operable to deliver the components one-at-a-time to a collection point (14), the magazine comprising a downwardly-inclined track (16) arranged to store a plurality of components one-behind-the-other, the track comprising an upper guide member (20), a lower guide member, and two opposed side guide members, characterised in that the magazine also comprises a conveyor belt (30) arranged to receive components issuing from a lower end of the track and arranged to convey each component to the collection point, and gating means (62,64,74) operable to retain the components in the track and to release them one-at-a-time on to the conveyor belt, the gating means comprising a stop (62) mounted for movement between an operative position thereof in which it projects into the track so that a leading component (C1) in the track engages the stop so that the components are prevented from sliding down the track, and an inoperative position thereof in which the stop is clear of the track, the gating means also comprising a clamping member (74) mounted for movement between an operative position thereof in which it projects into the track and clamps the component (C2) following said leading component (C1) against one of said guide members thereby preventing the clamped component and following components from sliding down the track, and an inoperative position thereof in which said clamping member is clear of the track, and connecting means (64) connecting said stop and said clamping member arranged to ensure that, as said stop moves into its inoperative position, said clamping member moves into its operative position so that only one component is released from the track and, as said stop moves into its operative position, the clamping member moves into its inoperative position allowing the following components to move up to the stop.

2. A magazine according to claim 1, characterised in that the conveyor belt (30) is arranged to be driven a predetermined distance in response to each operation of the gating means to release a component, said distance being sufficient to carry the released component to the collection point (14).

3. A magazine according to either one of claims 1 and 2, characterised in that a further stop (56) projects across the conveyor belt and acts to define the collection point by preventing movement of a component which engages the stop by movement of the conveyor belt.

4. A magazine according to claim 3, characterised in that the position of said further stop (56) is adjustable along the conveyor belt (30).

5. A magazine according to any one of claims 1 to 4, characterised in that said stop (62) and said clamping member (74) of the gating means are mounted on a pivoted link (64) on opposite sides of the pivot (66) thereof.

6. A magazine according to any one of claims 1 to 5, characterised in that the spacing along the track of said stop (62) and said clamping member (74) of the gating means is variable.

7. A magazine according to any one of claims 1 to 6, characterised in that the clamping member (74) of the gating means is resiliently mounted.

8. A magazine according to any one of claims 1 to 7, characterised in that said gating means (62,64,74) is operable by a vertically-disposed piston and cylinder assembly when the gating means is vertically aligned with said assembly.

9. A magazine according to any one of claims 1 to 8, characterised in that the spacing between said upper and said lower guide members is increased for a portion of the track (16) below said gating means (62,64,74) and terminating at the lower end of the track.

10. A magazine according to any one of claims 1 to 9, characterised in that said conveyor belt (30) is driven by a motor (48) arranged to drive the conveyor belts of one or more similar magazines (10) mounted on a common frame (12) with said magazine.

_Fig_1

EP 0 301 691 A1

Fig-2

Fig_3

Fig_4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.3) |
|---|---|---|---|
| A | PATENT ABSTRACTS OF JAPAN volume 7, no. 103 (E-173) (1248), 6th May 1983; & JP - A - 58 023 458 (MITSUBISHI) 12-02-1983 --- | 1,6 | H 05 K 13/02 B 65 G 47/08 |
| A | PATENT ABSTRACTS OF JAPAN volume 9, no. 191 (M-402) (1914), 7th August 1985; & JP - A - 60 056 715 (MITSUBISHI) 02-04-1985 --- | 1 | |
| A | DE-A-2 815 899 (USM CORP.) * claims 1,4,6; page 9, lines 5-32; figures 1-4 * --- | 1,9 | |
| A | DE-A-3 217 531 (MULITTEST ELEKTRONISCHE SYSTEME) * page 10, line 4-21; page 11, line 11 - page 12, line 3; figures 1-3 * --- | 1 | |
| A | US-A-3 311 215 (CLARK et al.) * column 3, lines 49-73; figures 1-4 * --- | 1 | TECHNICAL FIELDS SEARCHED (Int. Cl.3) |
| A | US-A-3 008 562 (ÖHRNELL) * column 1, line 72 - column 2, line 55 * ----- | 1 | B 65 G 47/00 H 05 K 13/00 |

The present search report has been drawn up for all claims

| Place of search | Date of completion of the search | Examiner |
|---|---|---|
| BERLIN | 25-10-1988 | SIMON J J P |